(19) Europäisches Patentamt
European Patent Office
Office européen des brevets

(11) EP 0 615 280 B1

(12) **EUROPEAN PATENT SPECIFICATION**

(45) Date of publication and mention of the grant of the patent:
**22.09.1999 Bulletin 1999/38**

(51) Int Cl.[6]: **H01L 21/00**, C04B 35/10, B32B 18/00, B32B 33/00

(21) Application number: **93301764.2**

(22) Date of filing: **09.03.1993**

(54) **Electrostatic chuck**

Elektrostatische Halteplatte

Support électrostatique

(84) Designated Contracting States:
**CH DE FR GB IT LI NL**

(43) Date of publication of application:
**14.09.1994 Bulletin 1994/37**

(73) Proprietor: **TOTO LTD.**
**Kita-kyusyu-shi, Fukuoka (JP)**

(72) Inventors:
- **Kitabayashi, Tetsuo, c/o Toto Ltd.**
  **Kita-Kyusyu-shi, Fukuoka (JP)**
- **Watanabe, Toshiya, c/o Toto Ltd.**
  **Kita-Kyusyu-shi, Fukuoka (JP)**

(74) Representative: **Calamita, Roberto**
**Frank B. Dehn & Co.,**
**European Patent Attorneys,**
**179 Queen Victoria Street**
**London EC4V 4EL (GB)**

(56) References cited:
**EP-A- 0 339 903** **US-A- 4 735 926**

- **CHEMICAL ABSTRACTS, vol. 117, no. 12, 1992, Columbus, Ohio, US; abstract no. 122716t, T. WATANABE ET AL 'Electrostatic force and absorption current of alumina electrostatic chuck'; & JAPANESE JOURNAL OF APPLIED PHYSICS vol. 31, no. 7, JAPAN pages 2145 - 2150**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 615 280 B1

## Description

The present invention relates to an electrostatic chuck used to attractively fix articles such as semiconductor wafers by electrostatic force.

Electrostatic chucks provided with an internal electrode between a substrate and an insulating layer (dielectric layer) are used as wafer fixing jigs when semiconductor wafers are treated by plasma etching, CVD, ion plating or the like.

Such electrostatic chucks are required to perform so that a great electrostatic attractive force is produced during the application of voltage so that the attracted articles are prevented from falling, and that after removing the applied voltage the electrostatic attractive force is immediately decreased so that the attracted articles can be displaced with ease.

Means for increasing the electrostatic attractive force include, for example, means in which the insulating layer has a large dielectric constant (Japanese Patent Publications No. 60-59104 and No. 62-19060), the thickness of the insulating layer is controlled (Japanese Patent Laid-open Publication No. 57-64950) and the insulating layer has a volume resistivity in a given range (Japanese Patent Publication No. 61-14660 and Japanese Patent Laid-open Publication No. 2-22166). Means for making the displacement of attracted articles easy include, for example, means in which helium gas is blown between the chuck surface and an attracted article (Japanese Utility Model Laid-open Publication No. 2-120831) and applying a voltage with a polarity opposite to the voltage applied when the wafers are attracted (Japanese Patent Publication No. 2-63304).

Among the above-mentioned conventional means, the means for increasing the electrostatic attractive force rely only on the insulating layer, where the residual attractive force tends to become larger with an increase in electrostatic attractive force. Furthermore, with such means it takes as long as at least 60 seconds before the residual attractive force attenuates and the attracted article can be displaced with ease. This is unsuitable for those instances in which attracted articles should be displaced immediately after treatment. Hence, in such cases there is the disadvantage that other devices or additional operations other than the usual operations have to be used in order to make the displacement of attracted articles easy. In particular, there is a problem when such devices are used in a low temperature environment.

One reason for these problems is that the materials constituting the insulating layer (dielectric layer) of conventional electrostatic chucks do not allow its volume resistivity to be arbitrarily controllable over a wide range. For example, it has been proposed to add titania to alumina as a transition metal oxide. In this instance, composite oxide grains deposited between alumina grains increase with an increase in the amount of titania added, resulting in a remarkable dependence of electrical conductivity on electric field intensity. ie. the volume resistivity abruptly decreases at a certain electric field intensity that forms a border, making it impossible to maintain given electrostatic performance.

Reference is also made to Japanese Journal of Applied Physics, Part 1, 31(7), p. 2145-2150 disclosing electrostatic chucks composed of $Al_2O_3$ ceramics doped with 1.3 wt.% $TiO_2$ and 3.5 wt.% $Cr_2O_3$.

To solve the above problem, an object of the present invention is to provide an electrostatic chuck that allows arbitrary control of the volume resistivity of the insulating layer over a wide range during its manufacture and which can hence exhibit a stable electrostatic performance without regard to operating temperatures.

Thus, the present invention provides an electrostatic chuck comprising a substrate and formed thereon an internal electrode and an insulating layer, said insulating layer comprising a solid-solution which comprises alumina and 6.5 to 50 wt % of a transition metal oxide having the structure of a corundum and 0 to 2 wt % of another transition metal oxide.

The insulating layer preferably also comprises a glass component. Thus, the insulating layer may comprise grains of the solid solution with the glass component present in the grain boundaries of the solid solution grains.

The insulating layer preferably comprises not more than 2% by weight of another transition metal oxide, preferably not having a corundum structure. Particularly preferred is titania $TiO_2$. This is particularly preferred in addition to a glass component, in which case the insulating layer may comprise grains of the solid solution, a glass component present in the grain boundaries of the solid solution grains and not more than 2% by weight of a transition metal oxide preferably deposited in the grain boundaries of the solid solution grains. The insulating layer preferably has a volume resistivity of not higher than $10^{11}$ Ω.m.

The transition metal oxide herein used has the structure of a corundum. Since this corundum structure is similar to the crystal structure of alumina, the transition metal oxide can readily form a solid solution with alumina. Such a transition metal oxide may preferably be one of those capable of forming a solid solution with alumina and preferably may be chromia ($Cr_2O_3$), $Ga_2O_3$, $Fe_2O_3$, $V_2O_3$, $Rh_2O_3$ or $Ti_2O_3$. Chromia ($Cr_2O_3$) is particularly preferred.

Embodiments of the present invention will now be described with reference to the accompanying drawings, in which:

Fig. 1 illustrates an equivalent circuit of an electrostatic chuck according to the present invention;
Fig. 2 is a partial enlarged diagrammatic view of an insulating layer;

Fig. 3 shows the state of alumina($Al_2O_3$)-chromia($Cr_2O_3$) solid solution;

Fig. 4 is a graph showing the relationship between the proportion of chromia in the solid solution and its volume resistivity;

Fig. 5 is a graph showing the relationship between volume resistivity and electric field intensity;

Fig. 6 is a partial enlarged diagrammatic view of an insulating layer according to another embodiment;

Fig. 7 is a graph showing the relationship between the concentration of titania ($TiO_2$) and volume resistivity; and

Fig. 8 is a graph showing the relationship between the concentration of titania ($TiO_2$), the volume resistivity of an insulator, and electric field intensity.

As shown in Fig. 1, the electrostatic chuck according to the present invention comprises a substrate 1, an insulating layer 2 formed thereon, an internal electrode 3 formed between the substrate 1 and the insulating layer 2. The electrode 3 is connected to a DC power source 5 through a lead wire 4 and a semiconductor wafer W is directly connected to ground or electrically connected therewith by a plasma.

As will be seen from Fig. 2, a partial enlarged diagrammatic view of the insulating layer, the insulating layer 2 comprises solid-solution grains 21 comprising alumina and a transition metal oxide, and glass 22 present in grain boundaries of the solid-solution grains. Here, the transition metal oxide may preferably include those capable of forming a solid solution with alumina, specifically including chromia, $Ga_2O_3$, $Fe_2O_3$, $V_2O_3$, $Rh_2O_3$ and $Ti_2O_3$. Chromia ($Cr_2O_3$) is particularly preferred, which well assumes the crystal structure of a corundum, the crystal structure of which is similar to alumina. Fig. 3 shows the state of solid solution of alumina ($Al_2O_3$) and chromia ($Cr_2O_3$). As is seen from Fig. 3, a perfect solid solution is formed.

On the basis of the electrostatic chuck shown in Fig. 1, comprising a substrate 1, an insulating layer 2 formed thereon, an internal electrode 3 formed between the substrate 1 and the insulating layer 2, where the electrode 3 is connected to a DC power source 5 through a lead wire 4 and a semiconductor wafer W is directly connected to ground or electrically connected therewith by plasma, the present inventor has devised an equivalent circuit of the electrostatic chuck, and has elucidated from the equivalent circuit the relationship between i) attenuation time $t_s$ (the time required for residual electrostatic force to attenuate by 98% with respect to the saturated electrostatic force), ii) volume resistivity $\rho$ ($\Omega$.m) of the insulating layer at operating temperatures of the electrostatic chuck, iii) dielectric constant $\varepsilon_r$ of the insulating layer at operating temperatures of the electrostatic chuck, iv) distance d (m) between the internal electrode and the surface of the insulating layer and (v) gap $\delta$ (m) between attracted article and the surface of the insulating layer. This relationship is represented by the following expression:

$$t_s = 1.731 \times 10^{-11} \rho(\varepsilon_r + d/\delta)$$

wherein $\rho$ is a volume resistivity ($\Omega$.m) of the insulating layer, $\varepsilon_r$ is a dielectric constant of the insulating layer at operating temperatures of the electrostatic chuck; d is a distance (m) between the internal electrode and the surface of the insulating layer (i.e. thickness of the insulating layer); and $\delta$ is the gap (m) between an attracted article and the surface of the insulating layer.

It is seen from the above expression that the attraction-displacement performance on attracted articles at operating temperatures of electrostatic chucks greatly depends on the volume resistivity of their insulating layer. In other words, in order to exhibit a stable electrostatic performance without regard to operating temperatures, the volume resistivity of the insulating layer must be arbitrarily controllable over a wide range when electrostatic chucks are manufactured.

Alumina is presumed to have a volume resistivity of $10^{12}$ $\Omega$.m or more, and chromia a volume resistivity of $10^4$ $\Omega$.m or less. Furthermore, as stated above, alumina and chromia can be formed into a perfect solid solution. Hence, the volume resistivity of the insulating layer 2 can be controlled by changing the proportion of the chromia to be added. Fig. 4 is a graph showing the relationship between the proportion of chromia in the solid solution and its volume resistivity. As is seen from the graph, the volume resistivity of the insulating layer 2 can be arbitrarily controlled in a given range.

In the insulating layer 2 having the structure as shown in Fig. 2, the solid-solution grains 21 have a lower resistivity than the grain boundary glass 22, so that electric charges are conducted through the solid-solution grains 21. In this conduction, as shown in Fig. 5, electric currents flow according to Ohm's law even when the electric field intensity increases. Hence, no insulation failure occurs even with an abrupt increase in electric currents, so that an damage of silicon wafers can be prevented.

Fig. 6 is a partial enlarged diagrammatic view of an insulating layer according to another embodiment of the present invention. In this embodiment, the insulating layer 2 comprises solid-solution grains 21 comprising alumina and chromia (the transition metal oxide having the structure of a corundum), glass 22 present in the grain boundaries of the solid-solution grains, and deposits 23 of titania ($TiO_2$), a transition metal oxide having no corundum structure.

Fig. 7 is a graph showing the relationship between the concentration of titania ($TiO_2$) and volume resistivity. Fig. 8 is a graph showing the relationship between the concentration of titania ($TiO_2$), the volume resistivity of an insulator, and electric field intensity. As is seen from these graphs, it is difficult to control the volume resistivity within the range of from $10^6$ Ω.m to $10^{10}$ Ω.m. unless the titania ($TiO_2$), when added, is in a concentration of 2% by weight or less, resulting in a great dependence of volume resistivity on electric field intensity to tend to cause insulation failure due to abrupt increase in electric currents.

The electrostatic chuck according to the present invention can be manufactured in the manner described below. First, as starting materials, alumina powder and the transition metal oxide (chromia, $Cr_2O_3$) having the corundum structure, and preferably also titania ($TiO_2$) and a sintering aid that forms the glass component in the final product are made ready for use. These are weighed and then mixed and pulverized using a ball mill. To the resulting powdery mixture, a binder such as polyvinyl butyral (PVB) and a solvent such as toluene, isopropyl alcohol or n-butanol are added, followed by deaeration, aging and molding to form a green sheet. The green sheet thus formed is laminated to an unfired substrate made of $Al_2O_3$ or the like (the same material as used in the insulating layer) on which an electrode layer comprising tungsten, molybdenum or the like has been printed, followed by firing in a reducing atmosphere at about 1,500°C to about 1,650°C (usually at about 1,600°C) for about 1 hour to about 7 hours (usually about 2 hours). Thus an electrostatic chuck is obtained.

The alumina may be added in an amount of from 41 to 91% by weight. The transition metal oxide having the corundum structure should conveniently be added in an amount of from 6.5% by weight to 50% by weight. Its addition in an amount more than 50% by weight makes it impossible to carry out satisfactory firing. As the sintering aid, silica sand, clay, glass frit, a carbonate or nitrate of an alkaline earth metal such as $MgCO_3$, $CaCO_3$, $SrCO_3$ or $BaCO_3$ may be used, which should conveniently be added in an amount of from 5% by weight to 12% by weight. The reason therefor is that its addition in an amount less than 5% by weight may result in a shrinkage of ceramics to cause a lowering of breakdown voltage, and its addition in an amount more than 12% by weight may result in the formation of a liquid layer at a low temperature to make it impossible to carry out satisfactory firing.

EXAMPLE

With regard to insulating layers of electrostatic chucks according to the present invention and conventional electrostatic chucks, their volume resistivity, attenuation time at various temperatures, and leak current were measured at an electric field intensity of 1.67 x $10^6$ V/m. The results obtained are shown in Table 1.

The electrostatic chucks used in the measurement were prepared by mixing and pulverizing alumina, chromia ($Cr_2O_3$) and titania ($TiO_2$) used in the amounts (% by weight) shown in Table 1 and 9% by weight, in terms of oxide, of MgO and CaO as sintering aids in a ball mill, and adding PVB as a binder and toluene and butyl acetate to the resulting powdery mixture, followed by deaeration, aging and molding to form a green sheet. The green sheet thus formed was laminated to a substrate made of $Al_2O_3$, having been similarly formed into a green sheet and on which an electrode layer comprising tungsten had been printed, followed by firing in a reducing atmosphere of a hydrogen-nitrogen mixed gas at 1,600°C for 2 hours.

Table 1 (cont'd)

| Sample No. | $Al_2O_3$ concentration | $Cr_2O_3$ concentration | $TiO_2$ concentration | Volume resistivity (room temp.) | Attenuation time | | | Leak current per 6 in. Room temp. | Remarks |
|---|---|---|---|---|---|---|---|---|---|
| | | | | | Room temp. | -50°C | +200°C | | |
| | (wt.%) | (wt.%) | (wt.%) | (Ω·m) | (sec) | (sec) | (sec) | (mA) | |
| 16 | 68.7 | 21 | 1.3 | $1.0\times10^{8}$ | <3 | 3 | <3 | 14.3 | Y |
| 17 | 53.7 | 38 | 1.3 | $3.0\times10^{7}$ | <3 | <3 | <3 | 43.1 | Y |
| 18 | 39.7 | 50 | 1.3 | $1.0\times10^{7}$ | <3 | <3 | <3 | 155 | Y |
| 19 | 89.3 | 0 | 1.7 | $4.0\times10^{10}$ | 130 | 1,000 | <3 | 0.04 | X |
| 20 | 85.8 | 3.5 | 1.7 | $4.0\times10^{9}$ | 15 | 100 | <3 | 0.42 | X |
| 21 | 82.8 | 6.5 | 1.7 | $1.2\times10^{9}$ | 4 | 30 | <3 | 1.3 | Y |
| 22 | 79.8 | 9.5 | 1.7 | $4.8\times10^{8}$ | <3 | 15 | <3 | 3.1 | Y |
| 23 | 88.8 | 0 | 2.2 | $2.5\times10^{6}$ | <3 | <3 | <3 | 501 | X |
| 24 | 85.3 | 3.5 | 2.2 | $2.2\times10^{6}$ | <3 | <3 | <3 | 670 | X |
| 25 | 82.3 | 6.5 | 2.2 | $1.5\times10^{6}$ | <3 | <3 | <3 | 980 | X |
| 26 | 79.3 | 9.5 | 2.2 | $1.0\times10^{6}$ | <3 | <3 | <3 | >1,000 | X |
| 27 | 88.2 | 0 | 2.8 | $3.0\times10^{4}$ | <3 | <3 | <3 | >1,000 | X |
| 28 | 84.7 | 3.5 | 2.8 | $2.5\times10^{4}$ | <3 | <3 | <3 | >1,000 | X |
| 29 | 81.7 | 6.5 | 2.8 | $2.0\times10^{4}$ | <3 | <3 | <3 | >1,000 | X |
| 30 | 78.7 | 9.5 | 2.8 | $2.0\times10^{4}$ | <3 | <3 | <3 | >1,000 | X |

X: Comparative Example

Y: Present Invention

Table 1 (cont'd)

| Sample No. | $Al_2O_3$ concentration | $Cr_2O_3$ concentration | $TiO_2$ concentration | Volume resistivity (room temp.) | Attenuation time | | | Leak current per 6 in. Room temp. | Remarks |
|---|---|---|---|---|---|---|---|---|---|
| | | | | | Room temp. | -50°C | +200°C | | |
| | (wt.%) | (wt.%) | (wt.%) | (Ω·m) | (sec) | (sec) | (sec) | (mA) | |
| 16 | 68.7 | 21 | 1.3 | $1.0\times10^{8}$ | <3 | 3 | <3 | 14.3 | Y |
| 17 | 53.7 | 38 | 1.3 | $3.0\times10^{7}$ | <3 | <3 | <3 | 43.1 | Y |
| 18 | 39.7 | 50 | 1.3 | $1.0\times10^{7}$ | <3 | <3 | <3 | 155 | Y |
| 19 | 89.3 | 0 | 1.7 | $4.0\times10^{10}$ | 130 | 1,000 | <3 | 0.04 | X |
| 20 | 85.8 | 3.5 | 1.7 | $4.0\times10^{9}$ | 15 | 100 | <3 | 0.42 | X |
| 21 | 82.8 | 6.5 | 1.7 | $1.2\times10^{9}$ | 4 | 30 | <3 | 1.3 | Y |
| 22 | 79.8 | 9.5 | 1.7 | $4.8\times10^{8}$ | <3 | 15 | <3 | 3.1 | Y |
| 23 | 88.8 | 0 | 2.2 | $2.5\times10^{6}$ | <3 | <3 | <3 | 601 | X |
| 24 | 85.3 | 3.5 | 2.2 | $2.2\times10^{6}$ | <3 | <3 | <3 | 670 | X |
| 25 | 82.3 | 6.5 | 2.2 | $1.5\times10^{6}$ | <3 | <3 | <3 | 980 | X |
| 26 | 79.3 | 9.5 | 2.2 | $1.0\times10^{6}$ | <3 | <3 | <3 | >1,000 | X |
| 27 | 88.2 | 0 | 2.8 | $3.0\times10^{4}$ | <3 | <3 | <3 | >1,000 | X |
| 28 | 84.7 | 3.5 | 2.8 | $2.5\times10^{4}$ | <3 | <3 | <3 | >1,000 | X |
| 29 | 81.7 | 6.5 | 2.8 | $2.0\times10^{4}$ | <3 | <3 | <3 | >1,000 | X |
| 30 | 78.7 | 9.5 | 2.8 | $2.0\times10^{4}$ | <3 | <3 | <3 | >1,000 | X |

X: Comparative Example

Y: Present Invention

As is seen from Table 1, since the electrostatic chucks according to the present invention have an insulating layer comprising i) solid-solution grains comprising alumina and a transition metal oxide having the structure of a corundum, and preferably a glass component present in grain boundaries of the solid-solution grains, or ii) solid-solution grains comprising alumina and a transition metal oxide having the structure of a corundum, and preferably a glass component present in grain boundaries of the solid-solution grains and not more than 2% by weight of a transition metal oxide deposited in the grain boundaries of the solid-solution grains, it is possible to obtain an electrostatic chuck that allows arbitrary control of the volume resistivity of the insulating layer over a wide range during its manufacture and hence can exhibit a stable electrostatic performance without regard to operating temperatures.

## Claims

1. An electrostatic chuck comprising a substrate and formed thereon an internal electrode and an insulating layer, said insulating layer comprising a solid-solution which comprises alumina and 6.5 to 50 wt % of a transition metal oxide having the structure of a corundum and 0 to 2 wt % of another transition metal oxide.

2. An electrostatic chuck as claimed in claim 1 wherein said transition metal oxide having the structure of corundum is selected from $Cr_2O_3$, $Ga_2O_3$, $Fe_2O_3$, $V_2O_3$, $Rh_2O_3$ and $Ti_2O_3$.

3. An electrostatic chuck as claimed in any one of the preceding claims wherein said transition metal oxide having the structure of corundum is $Cr_2O_3$.

4. An electrostatic chuck as claimed in claim 3, wherein said another transition metal oxide is $TiO_2$.

5. An electrostatic chuck as claimed in any one of the preceding claims, wherein said insulating layer further comprises a glass component.

6. An electrostatic chuck as claimed in any one of the preceding claims wherein said insulating layer has a volume resistivity of not higher than $10^{11}$ Ω.m.

7. An electrostatic chuck as claimed in any one of the preceding claims, wherein said another transition metal oxide is present in grain boundaries of said solid solution.

## Patentansprüche

1. Elektrostatische Haltevorrichtung mit einem Substrat und einer auf diesem gebildeten internen Elektrode und eine Isolationsschicht, wobei die Isolationsschicht eine Feststofflösung aufweist, die Aluminiumoxid und 6,5 bis 50 Gew.-% eines Übergangsmetalloxids mit der Struktur von Korund und 0 bis 2 Gew.-% eines weiteren Übergangsmetalloxids umfaßt.

2. Elektrostatische Haltevorrichtung nach Anspruch 1, wobei das Übergangsmetalloxid mit der Korund-Struktur ausgewählt ist aus $Cr_2O_3$, $Ga_2O_3$, $Fe_2O_3$, $V_2O_3$, $Rh_2O_3$ und $Ti_2O_3$.

3. Elektrostatische Haltevorrichtung nach einem der vorangehenden Ansprüche, wobei das Übergangsmetalloxid mit der Korund-Struktur $Cr_2O_3$ ist.

4. Elektrostatische Haltevorrichtung nach Anspruch 3, wobei das weitere Übergangsmetalloxid $TiO_2$ ist.

5. Elektrostatische Haltevorrichtung nach einem der vorangehenden Ansprüche, wobei die Isolationsschicht außerdem einen Glasbestandteil umfaßt.

6. Elektrostatische Haltevorrichtung nach einem der vorangehenden Ansprüche, wobei die Isolationsschicht einen spezifischen Volumenwiderstand nicht höher als $10^{11}$ Ωm aufweist.

7. Elektrostatische Haltevorrichtung nach einem der vorangehenden Ansprüche, wobei das weitere Übergangsmetalloxid in den Korngrenzen der Feststofflösung vorliegt.

**Revendications**

1. Support électrostatique comprenant un substrat et une électrode interne et une couche isolante formées sur le substrat, la couche isolante comprenant une solution solide qui comporte de l'alumine et de 6,5 à 50% en poids d'un oxyde d'un métal transitoire ayant la structure d'un corundium et de 0 à 2% en poids d'un autre oxyde de métal transitoire.

2. Support électrostatique selon la revendication 1, dans lequel l'oxyde de métal transitoire ayant la structure de corundium est choisi parmi $Cr_2O_3$, $Ga_2O_3$, $Fe_2O_3$, $V_2O_3$, et $Rh_2O_3$ et $Ti_2O_3$.

3. Support électrostatique selon l'une quelconque des revendications précédentes, dans lequel l'oxyde de métal transitoire ayant la structure de corundium est du $Cr_2O_3$.

4. Support électrostatique selon la revendication 3, dans lequel l'autre oxyde de métal transitoire est du $TiO_2$.

5. Support électrostatique selon l'une quelconque des revendications précédentes, dans lequel la couche isolante comporte en outre un composant du verre.

6. Support électrostatique selon l'une quelconque des revendications précédentes, dans lequel la couche isolante a une résistivité volumique électrique inférieure à $10^{11}$ $\Omega$.m.

7. Support électrostatique selon l'une quelconque des revendications précédentes, dans lequel l'autre oxyde de métal transitoire est présent dans les limites de grain de ladite solution solide.

**FIG. 1**

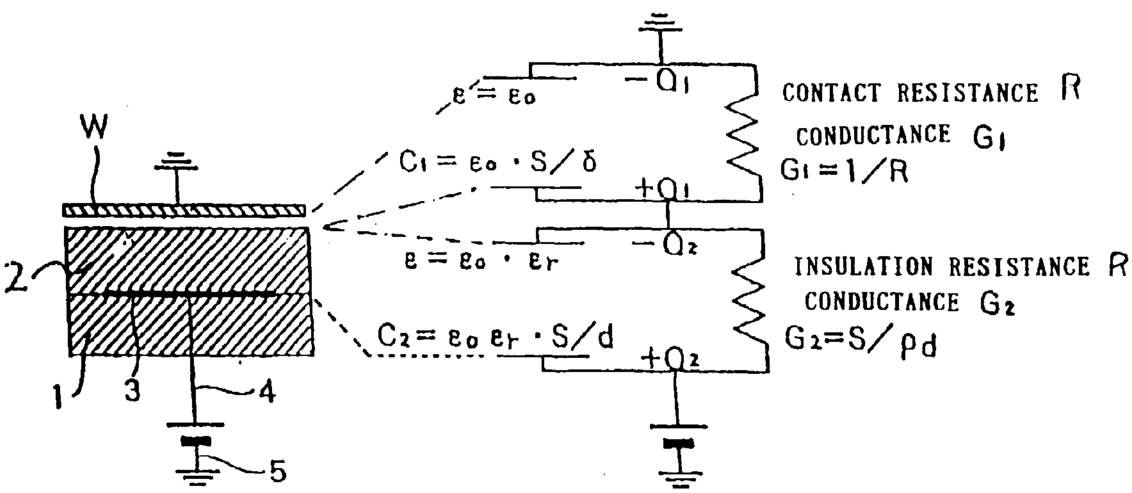


δ: gap when attracted

d: insulating layer thickness

FIG.2

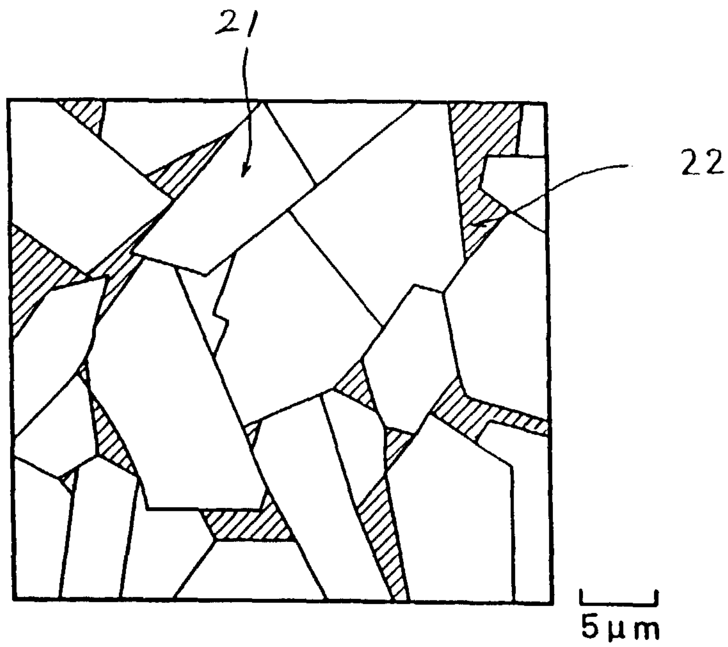


FIG.3

STATE OF $Al_2O_3$-$Cr_2O_3$ SOLID SOLUTION

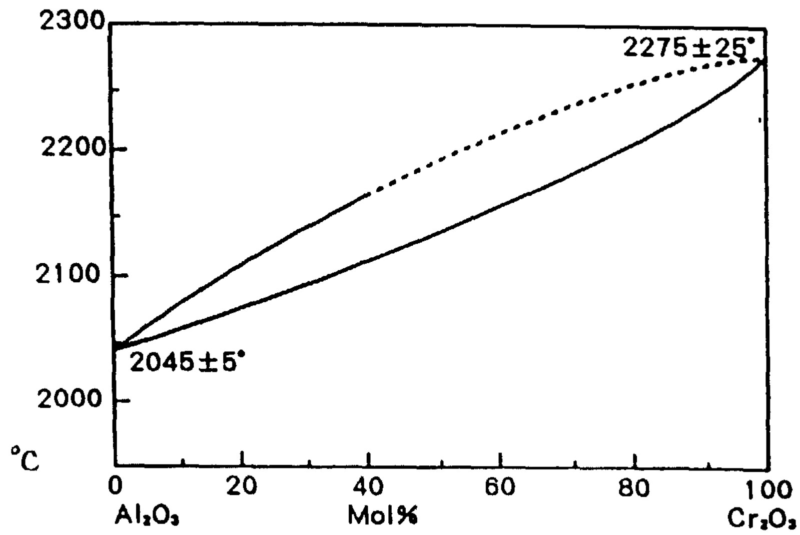

FIG. 4

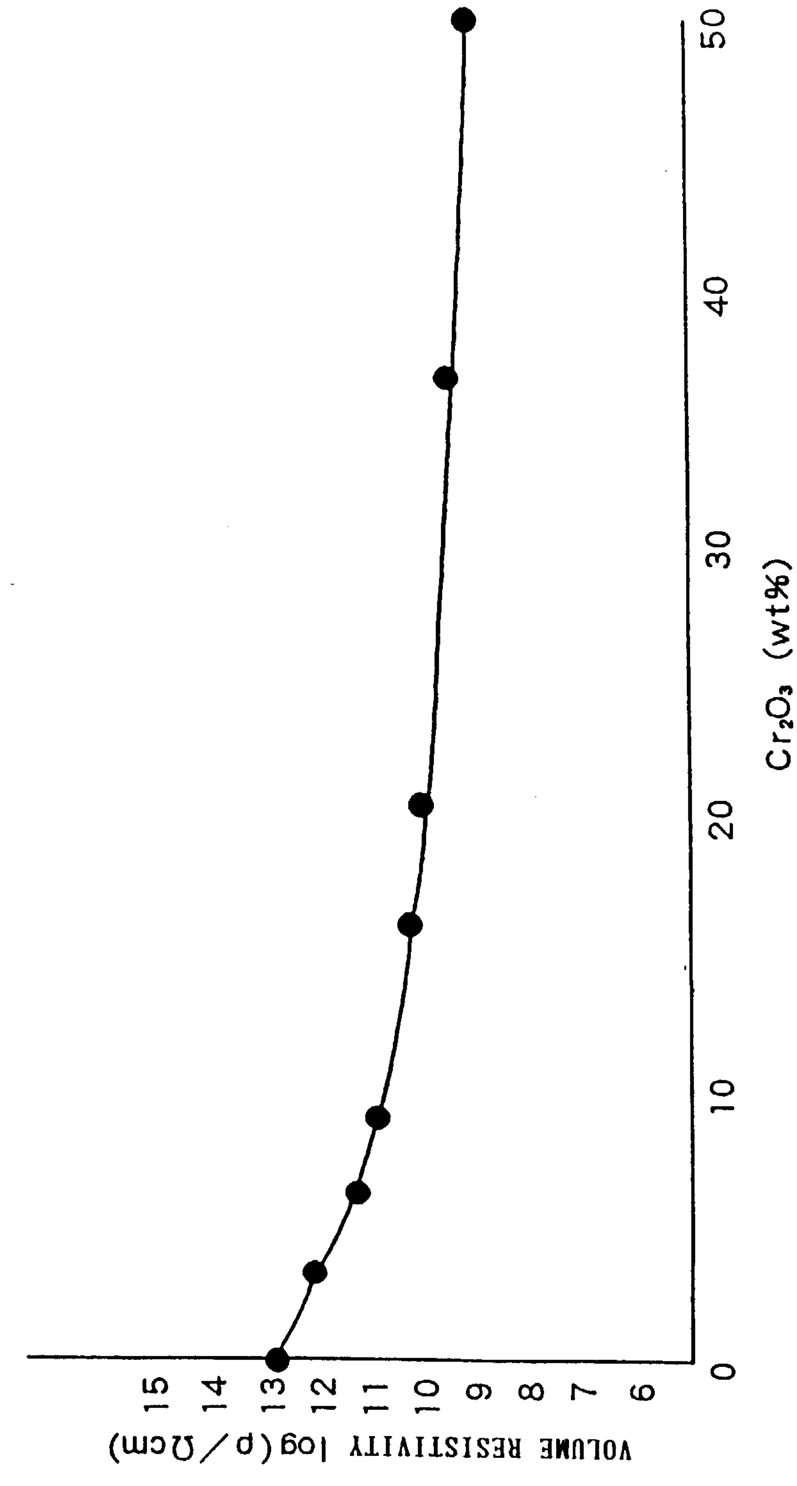
VOLUME RESISTIVITY log(ρ/Ωcm)
15
14
13
12
11
10
9
8
7
6
0
10
20
30
40
50
Cr2O3 (wt%)

# FIG.5

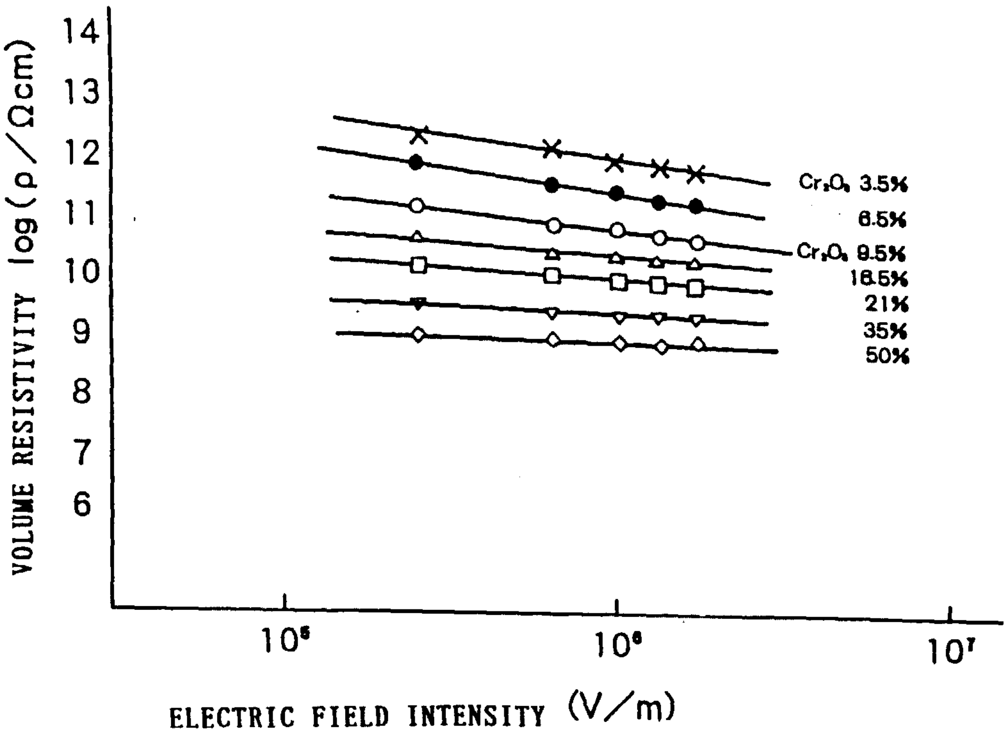
14
13
12
11
10
9
8
7
6
VOLUME RESISTIVITY log(ρ/Ωcm)
$10^5$
$10^6$
$10^7$
ELECTRIC FIELD INTENSITY (V/m)
$Cr_2O_3$ 3.5%
6.5%
$Cr_2O_3$ 9.5%
16.5%
21%
35%
50%

# FIG.6

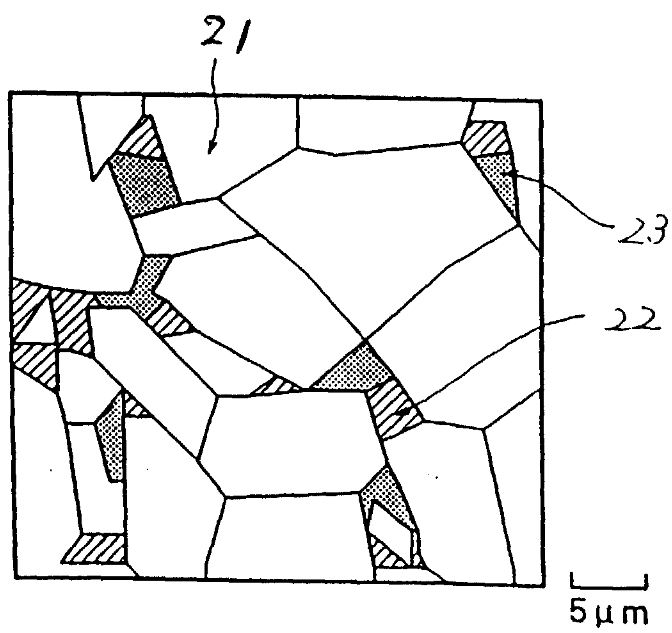
21
23
22
5μm

FIG.7

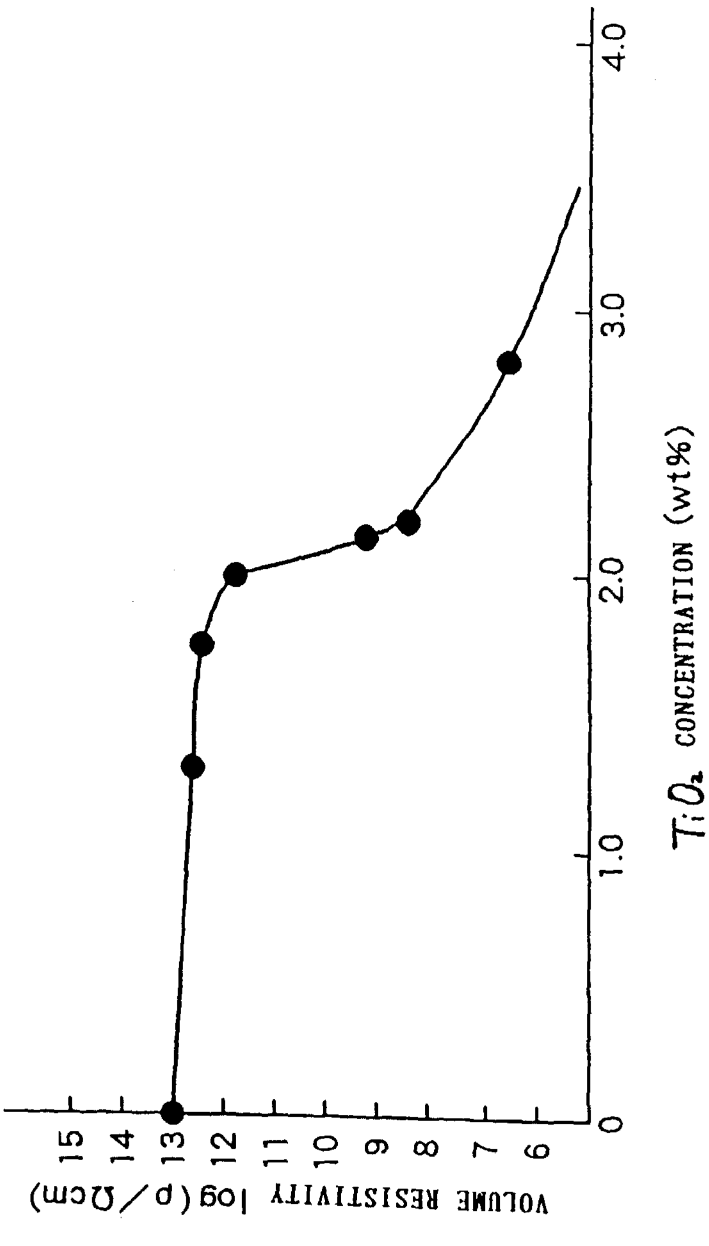
VOLUME RESISTIVITY log(ρ/Ωcm)
15
14
13
12
11
10
9
8
7
6
0
1.0
2.0
3.0
4.0
TiO2 CONCENTRATION (wt%)

FIG. 8

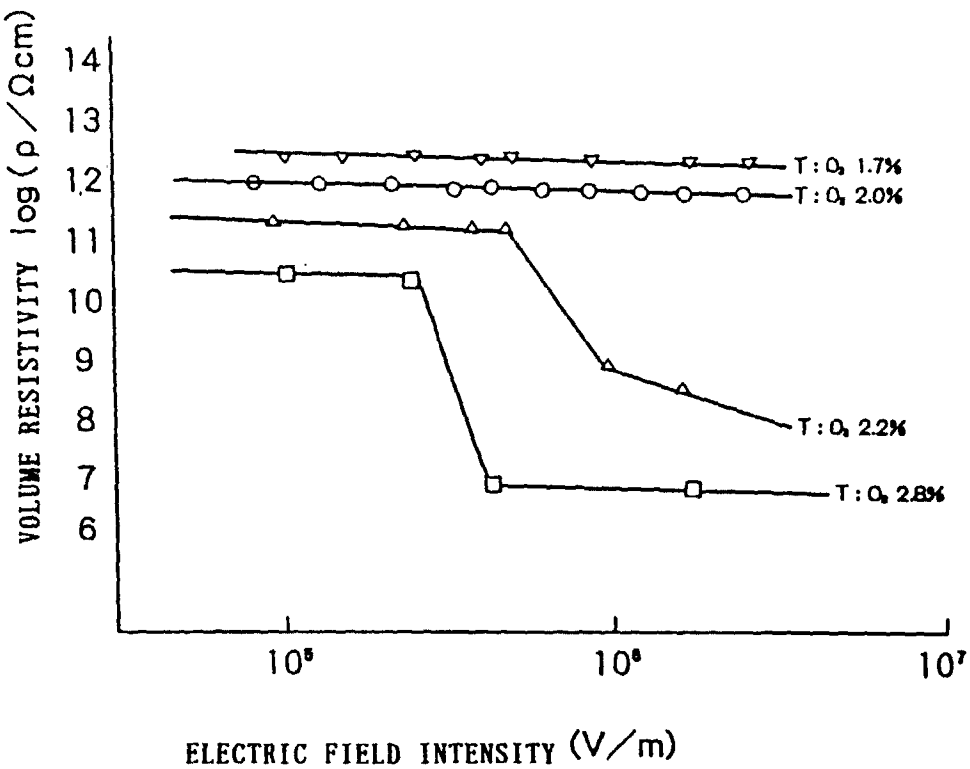
VOLUME RESISTIVITY log(ρ/Ωcm)
14
13
12
11
10
9
8
7
6
T : O₂ 1.7%
T : O₂ 2.0%
T : O₂ 2.2%
T : O₂ 2.8%
10⁵
10⁶
10⁷
ELECTRIC FIELD INTENSITY (V/m)